# EUROPEAN PATENT SPECIFICATION

(11) **EP 2 637 491 B1**
(45) Date of publication and mention of the grant of the patent: **12.06.2019**
(21) Application number: 11838018.7
(22) Date of filing: 01.11.2011
(51) Int. Cl.: H05K 13/02, B65G 47/06, B65G 11/02, H05K 13/00

(54) **POSITIONING AND STRUCTURE OF PART RECEPTACLE STICK FOR PART LOADING**
POSITIONIERUNG UND STRUKTUR EINES TEILEAUFNAHMEELEMENTS ZUM LADEN VON TEILEN
POSITIONNEMENT ET STRUCTURE DE BARRE DE RÉCEPTION DE COMPOSANTS DESTINÉE AU CHARGEMENT DE COMPOSANTS

(30) Priority: 04.11.2010 JP 2010247267
(43) Date of publication of application: 11.09.2013
(73) Proprietor: Yazaki Corporation, Minato-ku Tokyo 108-8333 (JP)
(72) Inventor: HORI, Shigeo, Makinohara-shi Shizuoka 421-0407 (JP)
(74) Representative: Grünecker Patent- und Rechtsanwälte PartG mbB
(86) International application number: PCT/JP2011/075166
(87) International publication number: WO 2012/060368

(56) References cited:
- GB-A- 2 161 701
- JP-A- 10 224 083
- JP-A- 63 087 418
- JP-A- 2000 165 091
- US-A- 4 469 215
- US-A1- 2004 154 899

## Description

### [Technical Field]

The present invention relates to an arrangement structure for a component loading stick in order to load a plurality of components such as connector housings into a rectangular tubular component loading stick and to supply components to the next process.

### [Background Art]

US 4 469 215 A discloses a can counter slide. The slide is inclined so that the cans, when placed on the slide, will fit within the grooves and slide downwardly toward the lower end. At the lower end there is a plurality of photo-electric cells, one for each of the V-shaped grooves. These photo-electric cells sense and count each can as it slides off the lower end of the slide. A vibrator can be applied to the slide to cause the slide to vibrate and thereby enhance the ability of the cans to slide downwardly.
GB 2 161 701 A discloses a rack for use in handling integrated circuit components in the assembly of circuit boards, in which the I.C.'s are in carrier magazines comprises a plate having a plurality of pillars each for receiving a magazine so that the I.C.'s can be fed out of the magazines individually. The pillars vary in width according to the nature of the I.C.'s concerned, and are made rapidly interchangeable by providing each pillar with a pair of headed projections and providing the plate with keyhole slots to accept the projections.
Conventionally, in order to load a plurality of components into a substantially rectangular tubular long stick in series, and to supply the components one by one to the next process from a front opening of the stick, for example, it is described in PTL 1 that guiding concaves are formed on left and right inner walls of a transparent-resin-made stick, and a convex of an integrated circuit substrate as the component is slidingly engaged along the guiding concave, so that the components are allowed to be supplied one by one in a constant direction without overlapping with each other.

In a component feeder, the stick is inclined front side down, and vibrated so that the components in the stick fall down easily. Before supplying the components, front and rear openings of the stick are closed with covers so as to prevent the components from falling down. Upon supplying the components, the front side cover is removed so that the integrated circuit substrate is supplied from the front opening so as to be raised in a groove of a component holder.

### [Citation List]

### [Patent Literature]

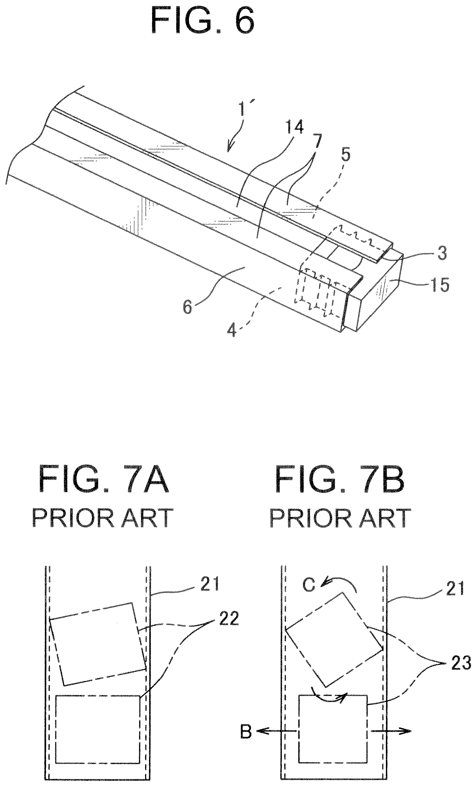

[PTL 1]
JP, A, 2001-85809 (Figs. 7 to 9, Fig. 28, Fig. 30)

### [Summary of Invention]

### [Technical Problem]

However, according to the conventional component loading stick, it is necessary to provide the concave for positioning and engaging with the convex of the component. Therefore, there is a problem that a stick structure becomes complex, and a labor to position and engage with the convex of the component with respect to the concave is needed. Further, depending on a size and/or a shape of the component, the convex of the component may not be inserted into the concave, or the convex may be removed from the concave. Therefore, it is necessary to form a plurality of component loading sticks with various sizes and shapes corresponding to the sizes and/or shapes of the components. Therefore, there is a problem that a resin molding cost of the stick is increased.

Further, as shown in Fig. 7A, when a resin component having no convex is used, and a component 22 having a size fitted to a component loading stick 21 is used, a movement of the component 22 in a horizontal direction is prevented, and a rotation of the component 22 in the horizontal direction and a vertical direction is prevented. However, as shown in Fig. 7B, when a component 23 having a size considerably smaller than a cross-sectional area in the stick 21 or a size of the stick 21 is used, positional deviation of the component 23 in a horizontal direction may be large as shown in an arrow B, and a rotation of the component 23 in the horizontal direction and a vertical direction may be occurred. Resultingly, the position of the component 23 cannot be controlled, and the component 23 cannot be supplied to the next process in a stable pose. Therefore, it is necessary to form component loading sticks fitted to the sizes and/or the shapes of the components 22, 23.

In view of the above, an object of the present invention is to provide an arrangement structure of a component loading stick able to supply components without positional deviation in a stable pose with a simple and common stick structure regardless of changes in sizes and/or shapes of the components.

### [Solution to Problem]

For achieving the above object, according to a first aspect of the present invention, there is provided an arrangement structure of a component loading stick including: an elongated component loading stick configured to transfer a plurality of components, the elongated component loading stick comprises: an upper rear end, a lower front end, a bottom wall and side walls, wherein one surface of the bottom wall of the component loading stick and one inner surface of one sidewall perpendicular to a lower end of the bottom wall are configured to support and position each of two surfaces perpendicular to each other of the plurality of components, wherein the components are supplied in a longitudinal direction of the stick from the lower front end of the elongated loading stick to a next process or to a next path, and wherein when the component is supplied from the front end of the component loading stick, the bottom wall of the component loading stick has been arranged horizontally, and after the component is supplied, the component loading stick is inclined such that the bottom wall is not arranged horizontally, but the bottom wall is inclined to a horizontal direction, and the one sidewall perpendicular to at least the lower end of the bottom wall is inclined to the horizontal direction, the arrangement structure further comprises means for generating an inclining action and a horizontal return action on the elongated component loading stick.

According to the above, the components in the stick are stably supported and positioned with two surfaces of the bottom wall of the stick and of the lower sidewall of the stick. A bottom surface and one side surface of the component are respectively abutted on the bottom wall and the one sidewall of the stick without a gap. Thereby, compared to a case that the stick is not inclined toward the circumferential direction and used horizontally, a rattle in the horizontal direction due to a gap between both left and right side surface of the component and both left and right sidewalls of the stick is prevented, and position accuracy is increased. Further, as long as the size and/or the shape of the component can be received in the stick, any component can be used. The term "circumferential direction" means not a longitudinal direction but a width direction of peripheral walls which are composed of the bottom wall and sidewall of the stick.

According to a second aspect of the present invention, there is provided the arrangement structure of the component loading stick as described in the first aspect,
wherein various sizes and/or shapes of the components which can be received in the stick are used.

According to the above, even a considerably small component in comparison to a cross-sectional area or a size of an inner space of the stick is correctly positioned when two surfaces perpendicular to each other of the component are abutted on inner surfaces of two walls perpendicular to each other of the stick without a gap. A conventional rattle (positional deviation) of the component in a horizontal direction and in a rotational direction in the stick is prevented.

According to a third aspect of the present invention, there is provided the arrangement structure of the component loading stick as described in the first or second aspect,
wherein the component is a connector housing.

According to the above, connector housings with various sizes and/or shapes as components of connectors with various sizes and/or shapes of a wiring harness are accurately positioned with a single type stick, and surely supplied to a terminal insertion process as the next process without mistake. Preferably, a plurality of connector housings with the same size and shape among various sizes and shapes is supplied in series with the same stick, thereby terminals can be smoothly and effectively inserted into the connector housings in the next process.

According to a fourth aspect of the present invention, there is provided the arrangement structure of the component loading stick as described in any one of the first to third aspects,
wherein when the component is supplied from a front end of the component loading stick, the incline toward the circumferential direction is eliminated, and after the component is supplied, the component loading stick is inclined toward the circumferential direction.

According to the above, the component is accurately positioned with two support surfaces in the stick inclined toward the circumferential direction, and then the stick is returned horizontally together with the component therein, and in this condition, the component in a horizontal pose is supplied to the next process. Therefore, the component in the horizontal pose can be supplied from the front end of the stick along, for example, a feeding path inclined front side down. Alternatively, a vertical chuck grasps the horizontal component and supplies to the next process easily (it becomes difficult to incline the chuck).

Preferably, a low positioning wall (separated from the stick) on which one side surface of the component abuts is arranged on an extension side at a front end of the one sidewall of the stick (for example, the feeding path), so that when the incline of the stick is eliminated (when the stick is moved to the horizontal pose), the component would not deviate horizontally. An incline action and a horizontal return action of the stick are, for example, done by an upthrust action and a return action of a cam, an air cylinder, or the like (driving member) about a crossing portion between the bottom wall and one sidewall of the stick.

### [Advantageous Effects of Invention]

According to the invention described in the first aspect, two surfaces perpendicular to each other of the component can be stably supported and accurately positioned by two walls perpendicular to each other of the stick. Thereby, the component can be supplied without mistake. Further, the components having various sizes and/or shapes can be accurately positioned with a single type stick as long as they can be received in the stick. Further, because it is unnecessary to form a concave or the like for positioning in the stick, the structure of the stick can be simplified and at low cost.

According to the invention described in the second aspect, even a considerably small component in comparison to a cross-sectional area of an inner space of the stick can be correctly positioned when the component is supported by the two surfaces perpendicular to each other of the stick. Thus, various components can be stably and accurately positioned with a single type stick regardless of the sizes and/or the shapes of the components. Therefore, by commoditizing the stick, a production cost and a management const of the stick can be reduced.

According to the invention described in the third aspect, connector housings having various sizes and/or shapes composing various connectors of a wiring harness can be accurately positioned with the single type stick, and can be surely supplied to the terminal insertion process as the next process without mistake.

According to the invention described in the fourth aspect, the incline of the stick can be eliminated, and the component can be supplied in a horizontal pose. Thereby, a labor or a device for returning the component in a horizontal pose one by one at a supply side can be eliminated.

### [Brief Description of Drawings]

Fig. 1 is a perspective view showing an embodiment of an arrangement structure of a component loading stick according to the present invention.
Fig. 2A is a front view showing a condition that the stick is arranged horizontally in a conventional way.
Fig. 2B is a front view showing a condition that the stick is arranged with an incline toward a circumferential direction.
Fig. 3 is a front view showing that the stick is loaded with components having various sizes and/or shapes.
Fig. 4A is a front view showing a member for inclining the stick in the circumferential direction.
Fig. 4B is a partially perspective front view showing the stick inclined in the circumferential direction.
Fig. 5 is a side view showing an embodiment of a component feeding path continued to the stick.
Fig. 6 is a perspective view showing a modified embodiment of the stick.
Fig. 7A is a plan view showing a normal condition that a conventional stick is loaded with a component.
Fig. 7B is a plan view showing a problem when the stick is loaded with a small component.

### [Description of Embodiments]

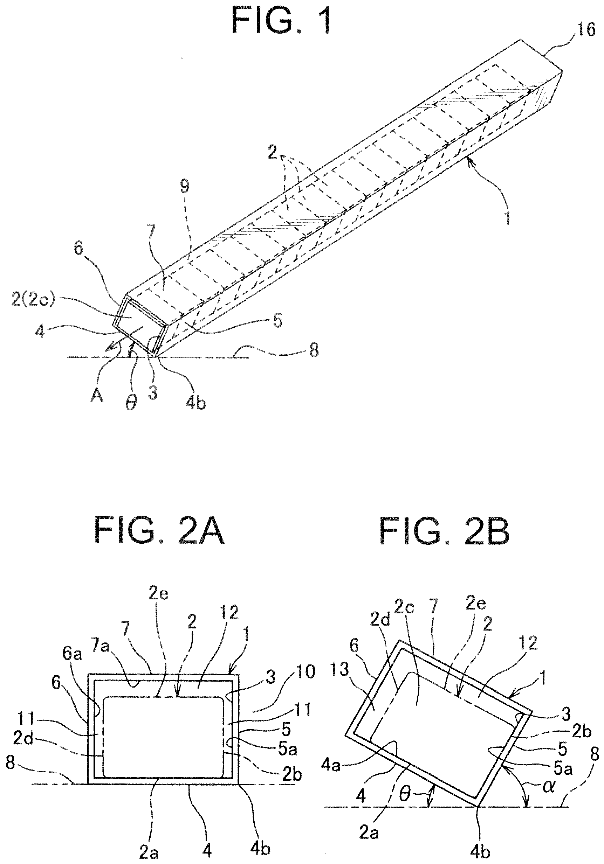

Figs. 1 to 3 show one embodiment of an arrangement structure of a component loading stick according to the present invention.

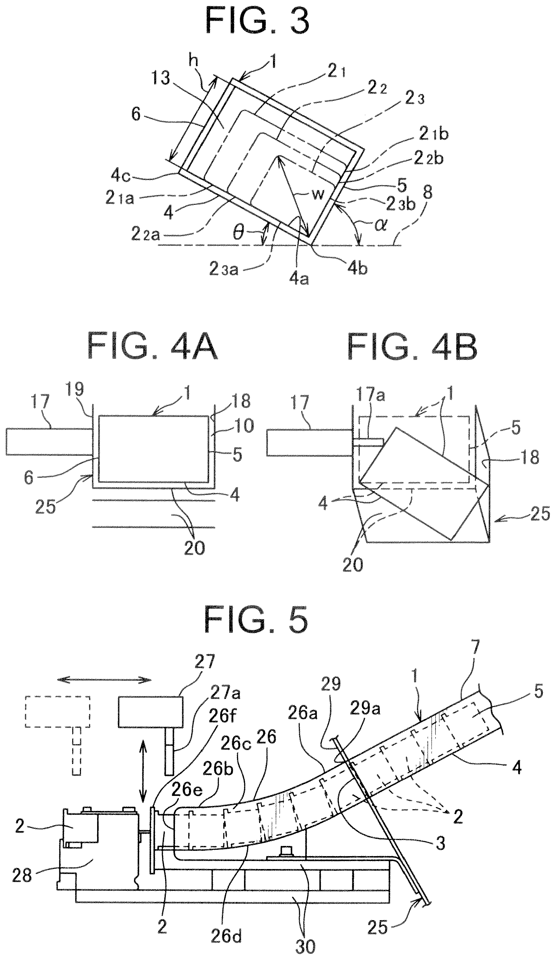

In this arrangement structure of the component loading stick, while a rectangular tubular component loading stick (hereinafter referred to as stick) 1 is loaded with rectangular box-shaped components 2 as shown in Fig. 1, a bottom wall 4 is not arranged horizontally as shown in Fig. 2 in a front view of the stick 1 (front opening 3), but the bottom wall is inclined right side down with an inclination angle θ as shown in Figs. 1 and 2B in a front view of the stick 1 (front opening 3), and one sidewall 5 perpendicular to at least a lower end 4b of the bottom wall 4 is inclined right side down with an inclination angle α (90degree -θ = α). Further, outer surfaces 2a, 2b of a bottom wall 2a and one sidewall 2b of the component 2 are supported by inner surfaces 4a, 5a of the bottom wall 4 and one sidewall 5 without a gap. Thus, as shown in Fig. 3, when sized and/or shapes of the components 2 (2₁ to 2₃) are changed, the components 2₁ to 2₃ can be supported with the bottom wall 4 and one sidewall 5 of the single type stick 1.

Preferably, a diagonal length w of a section of the components 2₁ to 2₃ in Fig. 3 is larger than an inner size (height) h of a short side of a section of the stick 1. Because the length w of the minimum component 2₃ is smaller than the height h, when an impact or the like is applied, the component 2₃ may be rotated 90 degree in the stick 1. However, there is no problem unless a big impact is applied.

In figures, reference sign 8 indicates a virtual horizontal line. In Fig. 1, the stick 1 is surrounded by left, right, upper, and lower walls 4 to 7 to have an inner space 9. A right side of Fig. 1 (wall 5 side) is referred to as a right side of the stick 1. Similarly, a front side of Fig. 1 (an arrow A direction in Fig. 1, namely, a feeding direction of the component 2) is referred to as a front side used in the following explanation. In stick 1, a plurality of components 2 having the same size and shape are arranged in series (in parallel is also acceptable) without a gap. Reference sign 3 denotes a front end (front opening) of the stick 1. Reference sign 16 denotes a rear end of the stick 1.

In the stick 1 of this embodiment, the bottom wall 4 is not only inclined right side down, but also inclined up side down (bottom side up), and the component 2 is fed to the front opening 3 of the stick 1 using at least its own weight. The component 2 of this embodiment is a synthetic-resin-made connector housing, and an opening of a not-shown terminal receiving chamber of the connector housing 2 is arranged at a front side in the stick 1.

The connector housing 2 is resin-molded with insulating resin material, and a robot takes out the connector housing 2 from a not-shown molding machine and loads the stick 1 with the connector housing 2. Alternatively, just after a retainer or the like for locking the terminal is assembled with (temporality locked with) the connector housing 2, the stick 1 is loaded with the connector housing 2 having the retainer. Alternatively, in a not-shown wiring harness production process, the connector housing 2 is taken out from a component bag, and the stick 1 is loaded with the connector housing 2 using a simple jig such as a gutter-shaped jig. The simple jig such as a gutter-shaped jig is also used when the robot loads the stick 1 with the connector housing 2. The capacity of the connector housings 2 in the stick 1 is changed depending on a size of the connector housing 2 in a depth direction (a longitudinal direction of the stick 1).

As shown in Fig. 2B, a operation to rotate and incline the stick 1 in a circumferential direction of the left, right, upper and lower walls (peripheral walls) 4 to 7 is easily and surely performed when a straight base member (not shown) along the bottom wall 4 or a substantially L-shaped base member (not shown) along the bottom wall 4 and one sidewall (right wall) 5 is previously inclined with a required inclination angle θ, and the stick 1 is put on the base member. For example, the inclination angle θ of the stick 1 in Fig. 2B is about 30 to 45 degrees. The inclination angle θ is properly set depending on material of the stick 1, surface roughness (sliding resistance), a shape or a weight of the connector housing 2.

Alternatively, while the stick 1 is arranged horizontally as shown in Figs. 2A and 4A, a crossing portion 4b between the bottom wall 4 and the one sidewall 5 of the stick 1 is used as a pivot point, it is possible to rotate and incline the stick 1 in the circumferential direction as shown in Figs. 2B and 4B when a driving member such as a rod 17a of an air cylinder 17, a not-shown plunger, a not-shown cam, or the like pushes a top of the other sidewall 6 of the stick 1. In this case, a space 10 is provided at a right side of the right wall 5 of the stick 1 in Figs. 2A and 4A for inclination, and a stopper wall 18 is provided at a right side of the right wall 5.

In Fig. 4, reference sign 25 denotes a frame of a component feeder. Reference signs 18, 19 denote left and right vertical sidewalls of the frame 25. Reference sign 20 denotes a bottom wall inclined front side down of the frame 25. It is also possible that the driving member such as the air cylinder 17 is provided upward not on the sidewall 19 but on a left half (near the sidewall 19) of the base wall (base member) 20 and pushes upward a left half of the stick 1 to incline the stick 1 in the circumferential direction.

It is also possible that when a front end 2c of the component 2 is positioned at the front opening 3 of the stick 1, the pushing of the driving member 17 is canceled, thereby the component 2 is returned horizontally from a condition that the component 2 is inclined right side down together with the stick 1. In this condition, a not-shown chuck may grasp a front half of the component 2 projected from the front opening 3 to supply the component 2 horizontally to the next process, or the component 2 may be supplied to the next process along an inclined feeding path (reference sign 26 in Fig. 5) from the front opening 3. In these cases, each time one of the components 2 is supplied, the driving member 17 inclines the stick 1, and repeats an inclination action and a horizontal return action.

When a plurality of sticks 1 are arranged in multiple columns, the stick 1 of the bottom column for supplying the component 2 may be inclined as shown in Fig. 2B. The sticks 1 are arranged in multiple columns in between left and right parallel walls 18, 29 of the frame 25 of the component feeder in Fig. 4A. Preferably, instead of the bottom wall 20, a horizontal pin member (not shown) rotatable in a horizontal direction by a driving member (not shown) may be used to allow each stick 1 to move downward along the left and right walls 18, 19 in the frame 25.

For example, while the stick 1 of the second column from the bottom is supported by a horizontal pin member (not shown), a stopper member (not shown) supporting the stick 1 of the bottom column is moved backward and escaped by a driving member (not shown) such as an air cylinder, thereby the empty stick 1 of the bottom column in which all the components 2 have been supplied is dropped down to a collection space (not shown) below the frame 25. Then, while the stopper member (not shown) is returned (moved forward), the stick 1 loaded with the components 2 of the second column from the bottom is pushed by a downward action of the pin member and arranged in the bottom column. A detailed explanation of this component feeder is omitted.

Further, it is also possible that while the sticks 1 in multiple columns are arranged horizontally, the frame 25 supporting the left and right walls 5, 6 is inclined right side down together with the sticks 1.

In the embodiment shown in Fig. 2A, small gaps 11 are generated between inner surfaces 5a, 6a of the left and right walls 5, 6 and outer surfaces 2b, 2d of the left and right walls of the component 2, and a middle gap 12 is generated between an inner surface 7a of an upper wall 7 of the stick 1 and an outer surface 2e of an upper wall of the component 2. Therefore, a little rattle of the component 2 is generated in the horizontal direction. However, as shown in Fig. 2B, when the stick 1 is inclined right side down, and the component 2 in the stick 1 is moved rightward, the right wall 2b of the component 2 is abutted on the right wall 5 of the stick 1 without a gap, the bottom wall 2a of the component 2 is abutted on the bottom wall 4 of the stick 1 without a gap, and two crossing surfaces 4a, 5a of the stick 1 support the two crossing surfaces 2a, 2b of the component 2. Thereby, the component 2 is supported in the stick 1 in a stable pose without a rattle in the horizontal direction. Because a rattle of the component 2 in the vertical direction is prevented by its own weight, it is not a considerable problem.

While the component 2 is inclined in the circumferential direction and stably supported by the stick 1 as shown in Fig. 2B, the stick 1 is also inclined front side down. Thereby, the component 2 is slidingly moved along the two surfaces 4a, 5a of the bottom wall 4 and the right wall 5 of the stick 1 by at least its weight, and smoothly supplied to the next process from the front opening 3 of the stick 1.

The wide surface (bottom surface) 2a of the component 2 is supported by the wide wall (bottom wall) 4, and the narrow surface (one side surface) 2b of the component 2 is supported by the narrow wall (sidewall) 5. It is also possible that a not-shown pushing member such as air pressure or a weight ball pushes forward the component 2 in addition to its own weight, or a not-shown vibration member vibrates the stick 1.

Further, as shown in Fig. 5, it is also possible to provide an inclined gutter-shaped feeding path (guiding path) 26 having a bottom wall 26d and left and right vertical walls 26c in between the front opening 3 of the stick 1 inclined right side down and the next process. An upper portion (rear portion) 26a of the feeding path 26 is inclined right side down, a middle portion of the feeding path 26 is curved, and a lower portion (front portion) 26b is positioned horizontally. A chuck 27 grasps the component 2 at the lower portion (front portion) 26b, and transfers the component 2 to a component receiver 28 of the next process.

A rear end of the rear portion 26a of the feeding path 26 is joined to an opening edge 29a of a front wall 29 of the frame 25 of the component feeder. The feeding path 26 is fixed to the front wall 29 of the frame 25 with a horizontal substrate 30. The component receiver 28 is provided at a front end side of the substrate 30. Left and right walls 26c at a front end 26b of the feeding path 26 are notched and opened (notched opening is denoted by reference sign 26e). While a front end of a leading component 2 is abutted on a vertical stopper wall 26f and stopped, and a front half of the component 2 is exposed from the notched opening 26e, a left and right pair of vertical claw portions 27a of the chuck 27 grasp the component 2, and the chuck 27 is moved upward and forward, and then moved downward to set the component 2 in the component receiver 28.

While the component (connector housing) 2 includes an opening of the not-shown terminal receiving chamber at a front end wall 2c, the component 2 is set in the component receiver 28, and a not-shown terminal having an electric wire is inserted into the terminal receiving chamber from the opening. When a retainer (not shown) for locking the terminal exists, while the retainer is temporarily locked with the connector housing 2 (floating condition), the retainer is sent to the component receiver 28 in a terminal insertion process, and then pushed to be permanently locked after the terminal is inserted.

The retainer in a temporary locking condition is arranged in a relatively wide space 12 at a top of the stick 1 in Fig. 2A. In Fig. 2B, because a left side space 13 becomes as wide as the upper space 12, it is also possible to arrange the retainer in the left side space 13. The upper space 12 is formed in between the upper wall 7 of the stick 1 and the upper surface 2e of the component 2. The left side space 13 is formed in between the left wall 6 of the stick 1 and the left surface 2d of the component 2.

As shown in Fig. 3, it is possible to stably position components 2₁ to 2₃ having different sizes in the stick 1 by supporting bottom surfaces 2ia, 2₂a, 2₃a and one sidewalls 2₁b, 2₂b, 2₃b with two surfaces of an inner surface 4a of the bottom wall 4 and an inner surface 5a of the one sidewall 5 of the stick 1. The largest component 2₁ in Fig. 3 is the same as the component 2 in Fig. 2. Because the component 21 is leaned to the one sidewall 5 side, a larger gap 13 is generated at the other sidewall 6 side than not leaned (a case of horizontal arrangement in Fig. 2A), and can receive a larger (wider) component than the component 2₁. The other sidewall 6 is continued to and perpendicular to an upper end 4c of the bottom wall 4.

In a case of the horizontal arrangement, a positional deviation in a horizontal direction and a positional deviation in a rotational direction are generated in the middle sized component 2₂ and the smallest component 2₃ as shown in the conventional embodiment of Fig. 7B. However, as shown in Fig. 3, when the components 2₂, 2₃ are rotated and inclined in the circumferential direction together with the stick 1, these positional deviations are eliminated, and these components 2₂, 2₃ are accurately positioned with two support surfaces. As described above, the diagonal length w of the smallest component 2₃ is smaller than the inner height h of the stick 1. Therefore, when a big impact or the like is applied, there is a fear that the component 2₃ is rotated clockwise 90 degrees, and it is the best to use a component 2 of which diagonal length w is larger than the inner height h of the stick 1.

Height, width and depth sizes of the connector housing 2 as the component are determined depending on the size and the number of the terminals received therein. Because usage patterns of the connector (composed of at least the connector housing 2 and the terminals) are wide-ranging, there are many types (size and/or shape) of the connector housing 2. To supply a wide variety of connector housings 2 with a single type (size and/or shape) stick 1 can reduce cost largely in comparison with a case that the stick 1 is resin-molded with respect to each type of the connector housing 2. Further, it is easy to manage, and needs no management cost. Further, there is no fear that an operator may miss-select the stick 1.

Fig. 6 shows the other embodiment (modified embodiment) of the resin-made stick 1'. This stick 1' is formed transparent or semitransparent in a rectangular tubular shape. A slit 14 is provided at the middle in a width direction of an upper wall 7 of upper, lower, left and right walls 4 to 7. Rubber plugs 15 are attached to front and rear openings 3 to prevent the component 2 from falling out when the stick 1' is transferred. The rubber plug 15 at the front opening 3 is pulled off when the component 2 is supplied (when the stick 1' is attached to the component feeder).

Owing to the slit 14, for example, a deformation upon resin-molding of the stick 1' is canceled, and the stick 1' in a correct size without warpage or the like is formed. Therefore, an effect of two supporting surfaces of the bottom wall 4 and the one sidewall 5 continued and perpendicular to a right end of the bottom wall 4 is correctly produced throughout a whole length of the stick 1'. The whole length of the stick 1' is, for example, about 400 millimeters. The stick 1' having the slit 14 is also formed in a rectangular tubular shape. When the stick 1' has the slit 14 or the like, the pushing member other than the air pressure is used except a drop of the component 2 by its own weight.

Incidentally, it is also possible to use a metallic rectangular tubular stick made by folding a light metal plate such as aluminum instead of the synthetic-resin-made sticks 1, 1'. Further, as shown in Fig. 3, the sticks 1, 1' are rotated and inclined in the circumferential direction, and the component 2 is supported by the bottom wall 4 and the lower one sidewall 5 (continued to the lower end 4b of the bottom wall 4). Therefore, any shape and any inclination angle are accepted in the higher other sidewall 6 and the upper wall 7 which do not contact the component 2, and a small hole or a slit smaller than the component 2 may be provided. In this case also, it is defined that the stick is formed in a rectangular tubular shape.

Further, it is also possible that the component 2 is positioned and supported by two surfaces of the bottom wall 4 and the one sidewall 5 perpendicular to the lower end 4b of the bottom wall 4 using a rectangular gutter shaped stick (not shown) composed of the bottom wall 4 and left and right sidewalls 5, 6 instead of the rectangular tubular sticks 1, 1'. In this case, because the stick has no upper wall 7, but an upper opening, it is hard to transfer the stick loaded with the components 2 (it is easy for the components 2 to fall down). However, the stick can be used. For example, when using a L-shaped sectional stick (not shown) composed of only two walls of the bottom wall 4 and the one sidewall 5, it is hard to use this stick because the component 2 fall down from the stick.

Further, in the embodiments described above, the connector housing is used as the component 2. However, it is also possible that a rectangular boxy relay, a rectangular boxy fusible link, or the like are used as the component 2 other than the connector housing. Further, the present invention is also effective for an arrangement method for the component loading stick, a component feeding method for component loading stick, and the like other than for the arrangement structure for the component loading stick.

### [Industrial Applicability]

The arrangement structure of the component loading stick according to the present invention can be used for supplying correctly a connector housing as the component to the next process without positional deviation by positioning accurately the connector housing at low cost using a single type component loading stick regardless of types (size and/or shape) of the connector housing, when the synthetic-resin-made connector housing is supplied to the terminal insertion process as the next process one by one in, for example, a production process of a wiring harness.

### [Reference Signs List]

1, 1' component loading stick
2 (2₁ to 2₃) component
2a, 2b two surfaces (outer surfaces)
3 front end (front opening)
4 bottom wall
4a, 5a inner surfaces
4b lower end
5 one sidewall

## Claims

1. An arrangement structure of a component loading stick (1, 1') comprising:
an elongated component loading stick (1, 1') configured to transfer a plurality of components (2),
the elongated component loading stick (1, 1') comprises:
an upper rear end (16), a lower front end (3), a bottom wall (4) and side walls (5, 6),
**characterized in that**
one inner surface (4a) of the bottom wall (4) of the component loading stick and one inner surface (5a) of one sidewall (5) perpendicular to a lower end (4b) of the bottom wall (4) are configured to support and position each of two surfaces (2a, 2b) perpendicular to each other of the plurality of components (2),
wherein the components (2) are supplied in a longitudinal direction of the stick from the lower front end (3) of the elongated component loading stick (1, 1') to a next process or to a next path, and
wherein when the component (2) is supplied from the front end (3) of the component loading stick (1, 1'), the bottom wall (4) of the component loading stick (1, 1') is arranged horizontally, and after the component has been supplied, the component loading stick (1, 1') is inclined such that the bottom wall (4) is not arranged horizontally, but the bottom wall (4) is inclined to a horizontal direction, and the one sidewall (5) perpendicular to at least the lower end (4b) of the bottom wall (4) is inclined to the horizontal direction,
the arrangement structure further comprises means for generating an inclining action and a horizontal return action on the elongated component loading stick (1, 1').

2. The arrangement structure of the component loading stick as claimed in claim 1, wherein various sizes and/or shapes of the components (2₁ to 2₃) which can be received in the stick are used.

3. The arrangement structure of the component loading stick as claimed in claim 1 or 2, wherein the component (2) is a connector housing.

## Patentansprüche

1. Anordnungsstruktur eines Bauteilbestückungs-Sticks (1, 1'), die umfasst:
einen länglichen Bauteilbestückungs-Stick (1, 1'), der zum Überführen einer Vielzahl von Bauteilen (2) eingerichtet ist,
wobei der längliche Bauteilbestückungs-Stick (1, 1') umfasst:
ein oberes hinteres Ende (16), ein unteres vorderes Ende (3), eine Bodenwand (4) und Seitenwände (5, 6),
**dadurch gekennzeichnet, dass**
eine Innenfläche (4a) der Bodenwand (4) des Bauteilbestückungs-Sticks (1, 1') und eine Innenfläche (5a) einer Seitenwand (5) senkrecht zu einem unteren Ende (4b) der Bodenwand (4) so eingerichtet sind, dass sie jede von zwei senkrecht zueinander angeordneten Flächen (2a, 2b) der Vielzahl von Bauteilen (2) stützen und positionieren,
wobei die Bauteile (2) in einer Längsrichtung des Sticks von dem unteren vorderen Ende (3) des länglichen Bauteilbestückungs-Sticks (1, 1') einem nächsten Prozess oder einem nächsten Weg zugeführt werden, und
wenn das Bauteil (2) von dem vorderen Ende (3) des Bauteilbestückungs-Sticks (1, 1') zugeführt wird, die Bodenwand (4) des Bauteilbestückungs-Sticks (1, 1') horizontal angeordnet ist, und, nachdem das Bauteil zugeführt worden ist, der Bauteilbestückungs-Stick (1, 1') so geneigt ist, dass die Bodenwand (4) nicht horizontal angeordnet ist, sondern die Bodenwand (4) zu einer horizontalen Richtung geneigt ist und die eine Seitenwand (5) senkrecht zu wenigstens dem unteren Ende (4b) der Bodenwand (4) zu der horizontalen Richtung geneigt ist,
und die Anordnungsstruktur des Weiteren Mittel zum Bewirken eines Neigungs-Vorgangs sowie eines horizontalen Rückstell-Vorgangs an dem länglichen Bauteilbestückungs-Stick (1, 1') umfasst.

2. Anordnungsstruktur des Bauteilbestückungs-Sticks nach Anspruch 1, wobei verschiedene Größen und/oder Formen der Bauteile (2₁ bis 2₃), die in dem Stick aufgenommen werden können, zum Einsatz kommen.

3. Anordnungsstruktur des Bauteilbestückungs-Sticks nach Anspruch 1 oder 2, wobei das Bauteil (2) ein Verbindergehäuse ist.

## Revendications

1. Structure d'agencement d'une barrette (1, 1') de chargement de composants comprenant :
une barrette (1, 1') allongée de chargement de composants configurée pour transférer une pluralité de composants (2),
la barrette (1, 1') allongée de chargement de composants comprend :
une extrémité arrière supérieure (16), une extrémité avant inférieure (3), une paroi de fond (4) et des parois latérales (5, 6),
**caractérisée en ce que**
la surface interne (4a) de la paroi de fond (4) de la barrette de chargement de composants et la surface interne (5a) d'une première paroi latérale (5) perpendiculaire à une extrémité inférieure (4b) de la paroi de fond (4) sont configurées pour supporter et pour positionner chacune de deux surfaces (2a, 2b) perpendiculaires l'une à l'autre de la pluralité de composants (2),
dans laquelle les composants (2) sont délivrés dans la direction longitudinale de la barrette depuis l'extrémité avant inférieure (3) de la barrette (1, 1') allongée de chargement de composants jusqu'à un processus suivant ou jusqu'à une ligne suivante, et
dans lequel, lorsque le composant (2) est délivré depuis l'extrémité avant (3) de la barrette (1, 1') de chargement de composants, la paroi de fond (4) de la barrette (1, 1') de chargement de composants est disposée horizontalement, et après que le composant a été délivré, la barrette (1, 1') de chargement de composants est inclinée de sorte à ce que la paroi de fond (4) ne soit pas disposée horizontalement, mais la paroi de fond (4) est inclinée vers une direction horizontale et la première paroi latérale (5) perpendiculaire à au moins l'extrémité inférieure (4b) de la paroi de fond (4) est inclinée vers la direction horizontale,
la structure d'agencement comprend en outre un moyen permettant de générer une action d'inclinaison et une action de retour à l'horizontale sur la barrette (1, 1') allongée de chargement de composants.

2. Structure d'agencement de la barrette de chargement de composants selon la revendication 1, dans laquelle sont utilisées des tailles et/ou des formes diverses pour les composants (2₁ à 2₃) qui peuvent être reçus dans la barrette.

3. Structure d'agencement de la barrette de chargement de composants selon la revendication 1 ou la revendication 2, dans laquelle le composant (2) est un boîtier de connecteur.
